# EUROPEAN PATENT SPECIFICATION

(11) **EP 0 611 944 B1**
(45) Date of publication and mention of the grant of the patent: **06.08.1997**
(21) Application number: 94301177.5
(22) Date of filing: 18.02.1994
(51) Int. Cl.: F42C 21/00, G01R 31/02

(54) **Testing circuit**
Testschaltung
Circuit de test

(30) Priority: 18.02.1993 ZA 931136
(43) Date of publication of application: 24.08.1994
(73) Proprietor: CSIR, Pretoria (ZA)
(72) Inventor: Marsh, Michael John Camille, Johannesburg, Transvaal (ZA); Hodson, Trevor Meredith, 2153 (ZA); Atkins, Raymond Catherall, Pretoria, Transvaal (ZA); Tolmay, James Pieter, Kilner Park, Pretoria, Transvaal (ZA)
(74) Representative: Tomlinson, Kerry John

(56) References cited:
- EP-A- 0 296 015
- WO-A-90/01670

## Description

### BACKGROUND OF THE INVENTION

This invention relates to a testing circuit for testing the operability of a load and a charge storage device arranged to discharge into the load.

South African patent 90/7794 filed in the name of the applicant is directed towards timing apparatus for activating a number of electronic detonators at predetermined time intervals. The central control and programming unit is linked to a series of the electronic detonators by means of a bidirectional harness, which is arranged in a loop. In order to ensure that spurious signals do not activate the detonators, a number of safety features have been incorporated into the timing apparatus. One such safety feature is the provision of separate logic and detonator circuits having separate lines from the central controller. The logic circuit is used to power up the detonator logic, and the separate detonator circuit is used to energize a charge storage device, such as a capacitor, just prior to initiation of the blasting sequence. By providing separate circuits, the logic circuitry can be tested in full without danger of the testing signals activating the electronic detonator circuit.

One disadvantage of the testing procedure described in South African patent 90/7794 is that it does not extend to testing of the detonator circuit, and especially the capacitor or the load.

### SUMMARY OF THE INVENTION

According to a first aspect of the invention there is provided a testing circuit for testing the operability both of a load and of a charge storage device incorporated into a main circuit and being arranged to discharge into the load for detonation of the load, the testing circuit comprising:
a) signal routing means for routing a test signal from a signal generator for storage in the charge storage device;
b) discharge means for allowing the charge storage device to provide a discharge signal by discharging through the load the charge derived from the test signal;
c) monitoring means for monitoring at least one of the parameters of the discharge signal, and
d) inhibiting means responsive to the monitoring means for inhibiting operation of the main circuit in the event of at least one of the monitored parameters falling outside predetermined limits, the limits being determined with reference to the operability both of the load and of the charge storage device.

Preferably, the monitoring means comprises a first switch which is arranged to be operated by the discharge signal, the first switch receiving a monitoring signal a predetermined time after the test signal, and having an output for delivering a discharge value signal in response to the discharge signal falling below a threshold value which operates the first switch.

Conveniently, the inhibiting means includes latching means for latching the output from the first switch.

The discharge means typically includes a second switch connected along a discharge path, and control means for controlling operation of the second switch, the control means being arranged to open the second switch once the testing circuit has operated, thereby preventing further discharge of the charge storage device along the discharge path.

The testing circuit typically is incorporated into an electronic detonator, which is linked, together with similar detonators, to a central controller via a harness. Both the test signal and the monitoring signal may be generated at the controller and transmitted via respective separate detonator power and logic power lines.

According to a further aspect of the invention there is provided a method of testing the operability both of a load and of a charge storage device incorporated in a main circuit and arranged to discharge into the load, the method including the steps of
a) generating a first test signal;
b) storing the first test signal in the charge storage device;
c) providing a discharge signal by allowing the charge storage device to discharge via the load;
d) monitoring at least one of the parameters of the discharge signal; and
e) inhibiting the operation of the circuit in the event of at least one of the monitored parameters falling outside predetermined limits.

Conveniently, the test signal is of such a magnitude and duration that it is not capable of activating or detonating the load on discharging through the load.

The parameters which are monitored may be time and/or magnitude parameters, and relate to the rate of discharge of the charge storage device, the rate of discharge being a function of an RC time constant, where C is the capacitance of the charge storage device and R includes the resistance of the load. Magnitude parameters may be monitored at a predetermined sampling time, whereas time parameters may be monitored at a predetermined magnitude threshold.

Conveniently, the method includes the steps of allowing the discharge signals to operate a first switch, generating a monitoring signal and supplying it to the first switch, a predetermined time after the first test signal, and monitoring a discharge value signal as an output from the switch.

The main circuit typically forms part of an electronic detonator, and the method conveniently includes the step of programming the electronic detonator with timing signals from a remote controller in the event of the monitored parameters falling within predetermined limits, charging the charge storage device from the remote controller and allowing the charge storage device to detonate the load.

An embodiment of the invention will now be described by way of example only and with reference to the accompanying drawings.

### BRIEF DESCRIPTION OF THE DRAWINGS

- Figure 1: shows a schematic block diagram of an electronic detonator;
- Figure 2: shows a simplified circuit diagram of a testing circuit of the invention for testing components of the detonator of Figure 1;
- Figure 3: shows a more detailed circuit diagram of the testing circuit of Figure 2;
- Figure 4: shows a waveform diagram illustrating the sequence of the operation of the simplified circuit of Figure 2;
- Figure 5: shows a waveform diagram illustrating the sequence of the operation of the more detailed circuit of Figure 3;
- Figure 6: shows a truth table indicating various fault conditions which can arise.

### DESCRIPTION OF THE EMBODIMENT

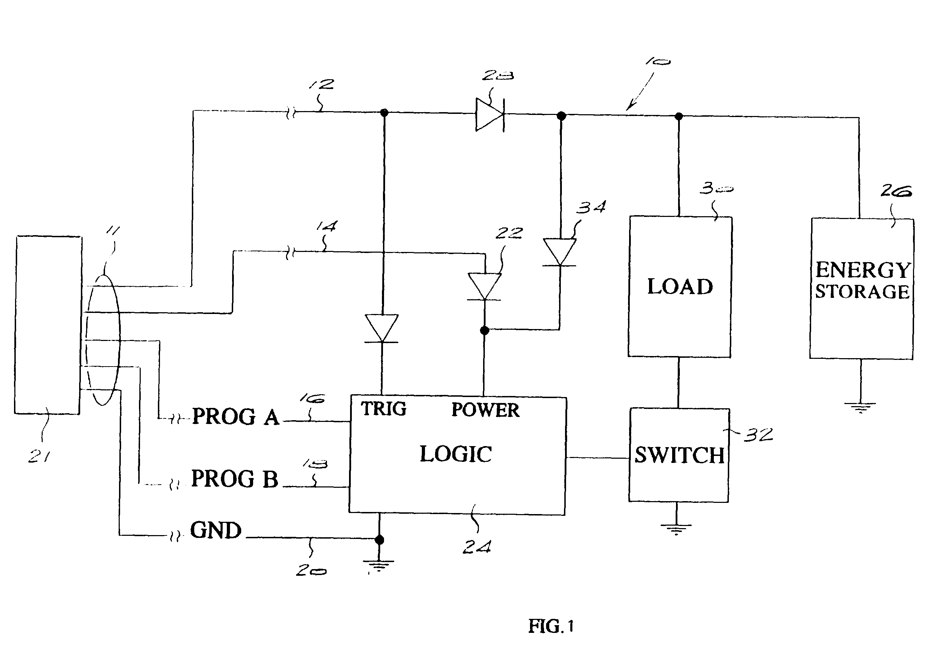

In Figure 1, an electronic detonator 10 is illustrated. The electronic detonator is similar to the delay devices described and illustrated in South African patent 90/7794. A harness 11 comprises a detonator power line 12, a logic power line 14, serially connected prog A and prog B lines 16 and 18 and a ground line 20, all of which interconnect the individual electronic detonators 10.

The opposite ends of the harness terminate at a central controller 21 which provides timing, testing and powering up signals. As is clear from Figure 1, there are two independent circuits, one being constituted by the logic power line 14 and the prog A and prog B lines 16 and 18. The other circuit, the main circuit, is constituted by the detonator power line 12, with the ground line 20 being common to both circuits. The logic power line 14 is connected via a diode 22 to logic circuitry 24 which forms the heart of the electronic detonator. The prog A and prog B lines 16 and 18 are arranged to deliver timing signals in serial form from the central controller to the logic circuitry 24. The detonator power line 12 is only powered up when the entire system is being armed just prior to final detonation.

The detonator power line 12 is arranged to charge an energy storage device which is typically in the form of a 35 V 100 µF capacitor 26. The capacitor 26 is in turn arranged to discharge through a load 30, which is typically a one ohm series resistor made from a high resistance wire compound which generates heat. The resistor is surrounded by a match-head-type chemical compound which ignites on heating of the resistor, thereby igniting the explosive compounds and detonating the main charge. The logic circuitry 24 controls the operation of the switch 32, closure of which will cause the capacitor 26 to discharge through the load 30.

Once the logic circuitry has been programmed with timing signals by the prog A and prog B lines 16 and 18 and testing has taken place, the detonator power line is raised so as to charge the capacitor 26.

Lowering of the detonator power line serves as a signal for the logic circuitry 24 to commence timing. All the harness lines are isolated from the central controller on lowering of the detonator power line, and the logic circuitry is thereafter powered from the capacitor 26 via a diode 34. Once the time period stored in the logic circuitry has counted down to zero, a signal from the logic circuitry 24 closes the switch 32, thereby causing the capacitor 26 to discharge into the load 30, so as to detonate it.

As the various electronic detonators are moved from one site to another, underground vibrations and similar disturbances may cause the solder connections which hold the load or anchor the capacitor 26 to vibrate loose, thereby resulting in the electronic detonator not functioning correctly or at all. In the electronic detonator which is being developed by the applicant, reliabilities of one in ten thousand are being aimed at. It is thus desirable to be able to test, prior to the blast, that the capacitor and the load are functioning properly and are connected correctly.

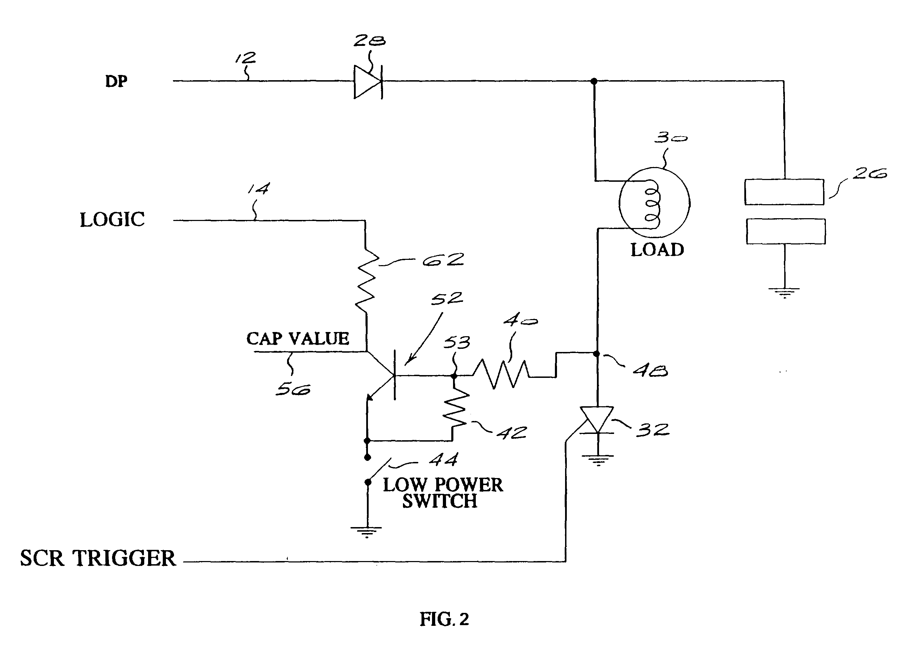

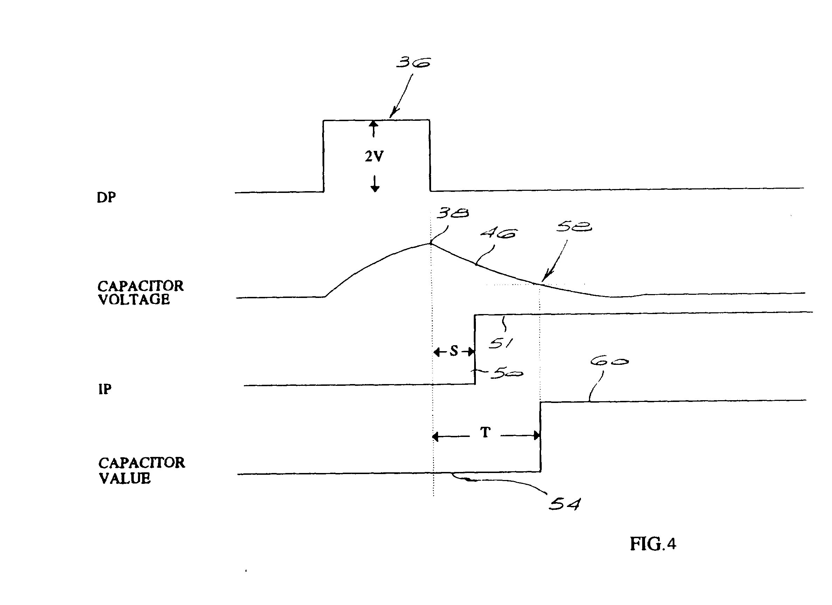

Referring now to Figures 2 and 4, before the logic power line 14 is powered up, a test pulse 36 is routed from the central controller along the detonator power line 12. The test pulse 36 has a duration of approximately 0.1 second and a magnitude of 2 volts. Assuming that the diode 28 is an ideal diode, the capacitor will charge up to 2 volts, as is shown at 38. On termination of the test pulse 36, the capacitor will discharge through the load and through resistors 40 and 42 to ground via a low power switch 44, which is in the closed position. The discharge signal 46 is indicated at node 53 and is a proportion of the signal at node 48.

Naturally, the rate of discharge will be a function of an RC time constant, where C is the capacitance of the capacitor 26 and R is the sum of the resistances of the load 30 and the resistors 40 and 42.

At a predetermined time S after the test pulse 36 has gone low, the logic power line 14 is raised, as is shown at 50, thereby providing a monitoring signal 51.

In the event of the magnitude of the discharge voltage 46 still exceeding the bias threshold of transistor 52 at node 53, the transistor 52 will remain on and a capacitor value signal 54 at a capacitor value output line 56 will stay low under influence of the earthed transistor 52. However, as soon as the discharge signal falls to a voltage 58 which is lower than the bias threshold at the base of the transistor 52, the transistor 52 will turn off and the capacitor value signal 54 is raised at 60 by means of a pull-up resistor 62 to a voltage which corresponds to the voltage on the logic line 14. The time T between termination of the test pulse 36 and the raising of the capacitor value line 56 is representative of the energy storing capabilities of the capacitor 26, in that it represents the time taken for the discharge signal to drop below the bias threshold of the transistor 52. Should the capacitor have broken free, for instance, then the time T will be extremely short. In the event of the load 30 having broken free, the capacitor value line will be held permanently high as soon as the logic power line is raised.

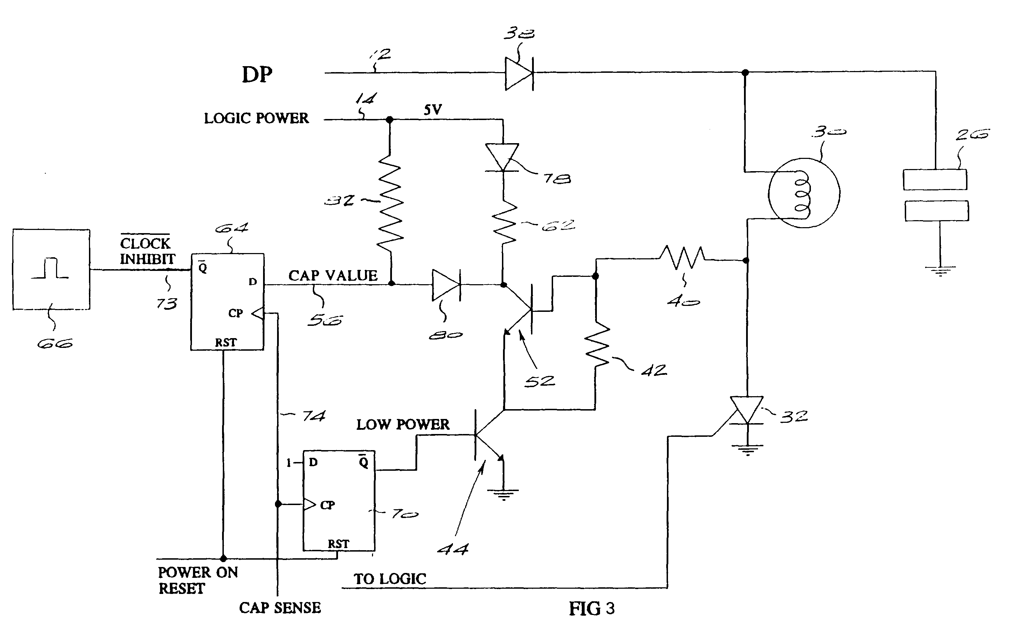

Referring now to Figure 3, the capacitor value line 56 is linked to the D input of a D-type flip-flop 64, which is used to sense the value of the capacitor 26 and to provide a clock inhibit signal to a local oscillator in the event of the load 30 or the capacitor 26 being faulty. The local oscillator is an on-board oscillator which is used to generate a time reference to calculate the timing delay prior to detonation.

The oscillator is a free running imprecise oscillator which is incorporated into the logic circuitry 24. The frequency of the oscillator is fed back to the central controller for calibration during the programming phase.
In the event of a detonator being faulty, a reliable method of passing this information on to the controller is to suppress the oscillator on startup, thereby not providing the necessary calibration signal and allowing the controller to indicate to the operator which electronic detonator is faulty.

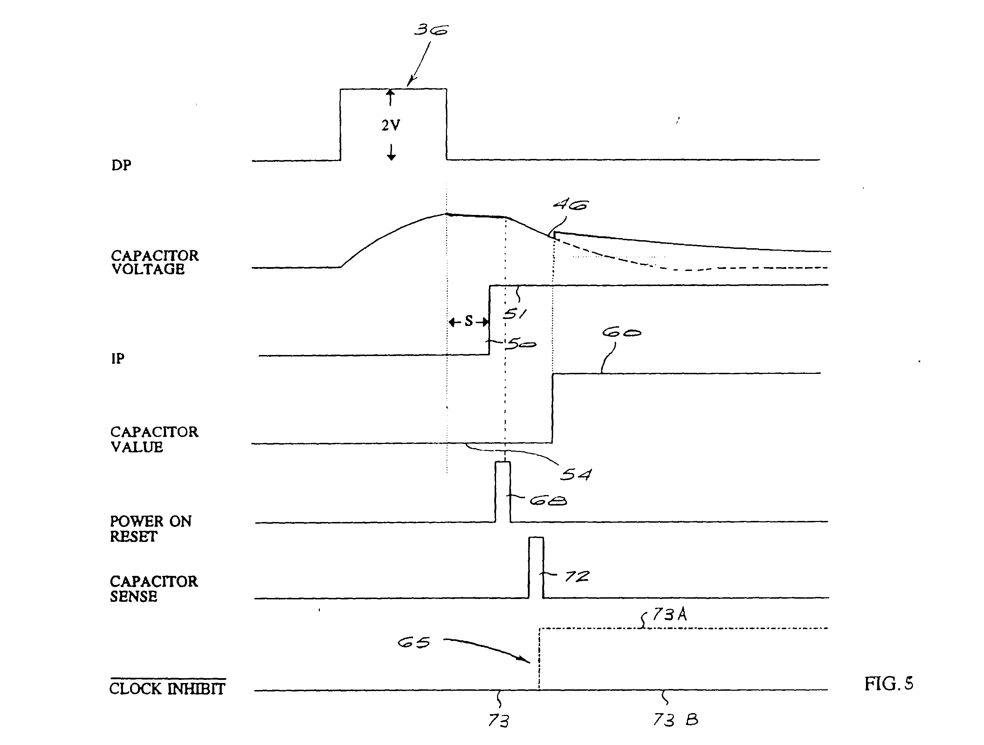

Referring now to Figure 3 in conjunction with Figure 5, a short time after the logic power line 14 is raised, the logic circuitry 24 generates a power-on reset pulse 68 which sets all the logic circuits to a known state. This also has the effect of resetting the D-type flip-flop 64 and a further D-type flip-flop 70. The inverted output of flip-flop 70 turns on transistor 44 to start the discharge process through the load 30, the resistors 40 and 42 and the transistor 44. A predetermined time after the power-on reset pulse 68 has been generated, a capacitor sense pulse 72 is generated by the logic circuitry 24. The capacitor sense pulse 72 travels via capacitor sense line 74 which is linked to the clock inputs of the flip-flops 64 and 70. This pulse 72 thus has the effect of strobing an inverted version of the capacitor value signal on the capacitor value line 56 through to clock inhibit line 73 at the inverting output of the flip-flop 64. Should the capacitor still have enough charge left to hold the transistor 52 on, the capacitor value line 56 will still be low and the clock inhibit line will go and remain high, as is shown at 73A, thereby enabling the oscillator to continue operation.

However, in the event of the capacitor 26 being under-rated or the load circuitry being broken, the capacitor value line 56 will already be high, and this will have the effect of holding or toggling the clock inhibit signal 73 to a low, as is indicated at 73B, which is then used to inhibit the oscillator and to upset the handshaking procedure between the electronic detonator 10 and the central controller.

The lack of clock signals arriving at the central controller will indicate to the central controller that a fault exists in respect of the electronic detonator in question.

In order to allow for long operation of the detonator circuitry using the energy stored in the capacitor 26, it is necessary to reduce the power draining from the capacitor 26 to an absolute minimum after the testing procedure. For this reason, the D-type flip-flop 70 is also toggled by the capacitor sense line 74. The inverting output of the flip-flop 70 is connected to the base of the low power switch 44, which is in the form of a transistor. Toggling of the flip-flop 70 will thus cause the transistor 44 to be turned off, thereby minimizing drainage through the resistors 40 and 42 when the circuit is not in use. As a consequence, the discharge signal 46 rises to and remains at the remaining voltage of capacitor 26, and the capacitor value signal 54 is raised to the voltage on the logic line 14. Gradual discharge of the capacitor 26 occurs via the leakage resistance of the capacitor. Blocking diodes 78 and 80 prevent any high voltage from the detonator power line 12 from flowing back into the logic power line 14. A pull-up resistor 82 ensures that the capacitor value line 56 is pulled up to the voltage on the logic power line 14 when one or both of the transistors 52 and 44 are off.

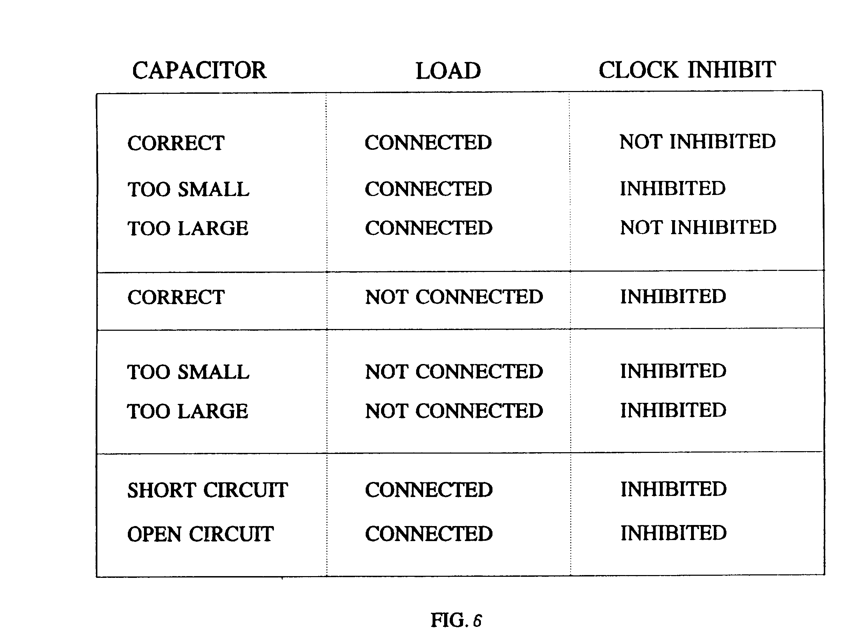

Figure 6 is a self-explanatory truth table indicating the different fault conditions which may arise in the capacitor and the load, and the effect of these fault conditions on the clock inhibit line.

The fault protection circuitry may be incorporated into the integrated circuits forming electronic detonators, thereby providing a means for safely monitoring both the performance of the capacitor and of the load before blasting takes place. This avoids the consequence of failure of the electronic detonators by allowing for their timely replacement during the testing process.

Naturally, the testing or fault detection circuitry of the invention is not confined for use in the particular timing apparatus, but may be used to test the operation of any load and any capacitor which is arranged to discharge into that load for the purposes of detonation or the like.

## Claims

1. A testing circuit characterised in that the testing circuit is arranged to test the operability both of a load (30) and of a charge storage device (26) incorporated into a main circuit (10) and being arranged to discharge into the load for detonation of the load, the testing circuit comprising:
a) signal routing means (12) for routing a test signal (36) from a signal generator (21) for storage in the charge storage device (26);
b) discharge means (24,40,42,44) for allowing the charge storage device (26) to provide a discharge signal (46) by discharging through the load the charge derived from the test signal;
c) monitoring means (52) for monitoring at least one of the parameters of the discharge signal (46), and
d) inhibiting means (64,73) responsive to the monitoring means (52) for inhibiting operation of the main circuit in the event of at least one of the monitored parameters falling outside predetermined limits (58), the limits being determined with reference to the operability both of the load (30) and of the charge storage device (26).

2. A testing circuit according to claim 1 characterised in that the monitoring means comprises a first switch (52) which is arranged to be operated by the discharge signal (46), the first switch receiving a monitoring signal (51) a predetermined time (S) after the test signal (38), and having an output (56) for delivering a discharge value signal (60) in response to the discharge signal (46) falling below a threshold value (58) which operates the first switch.

3. A testing circuit according to either one of the preceding claims characterised in that the inhibiting means includes latching means (64) for latching the output from the monitoring means (52).

4. A testing circuit according to any one of the preceding claims characterised in that the discharge means includes a second switch (44) connected along a discharge path and first control means (70) for controlling operation of the second switch (44), the control means being arranged to open the second switch once the testing circuit has operated, thereby preventing further discharge of the charge storage device (26) through the discharge means.

5. A testing circuit according to any one of the preceding claims characterised in that the monitoring means further includes means (24) for providing a first signal (68) for causing the discharge means (40,42,44) to commence discharging the charge storage device (26), means (24) for providing a second signal (72) a fixed time after the first signal (68), and means (64) responsive to the second signal (72) for controlling the inhibiting means in response to the voltage of the discharge signal at said fixed time.

6. A testing circuit according to any one of the preceding claims characterised in that at least part of the testing circuit is incorporated into an electronic detonator (10), which is linked, together with similar detonators, to a central controller (21) via a harness (11).

7. A testing circuit according to claims 2 and 6 characterised in that both the test signal (36) and the monitoring signal (51) are generated at the controller and transmitted via respective separate detonator power (12) and logic power (14) lines.

8. A method of testing the operability both of a load (30) and of a charge storage device (26) incorporated in a main circuit (10) and arranged to discharge into the load, characterised in that the method includes the steps of
a) generating a first test signal (36);
b) storing the first test signal in the charge storage device (26);
c) providing a discharge signal (46) by allowing the charge storage device (26) to discharge via the load;
d) monitoring at least one of the parameters of the discharge signal (46); and
e) inhibiting the operation of the circuit in the event of at least one of the monitored parameters falling outside predetermined limits (58).

9. A method according to claim 8 characterised in that the test signal (36) is of such a magnitude and duration that it is not capable of activating or detonating the load (30) on discharging through the load.

10. A method according to either one of claims 8 or 9 characterised in that the parameters which are monitored include the voltage of the discharge signal and relate to the rate of discharge of the charge storage device (26), the rate of discharge being a function of an RC time constant, where C is the capacitance of the capacitor (26) and R includes the resistance of the load (30).

11. A method according to any one of claims 8 to 10 characterised in that it includes the steps of allowing the discharge signal (46) to operate a first switch (52), generating a monitoring signal (51) and supplying it to the first switch, a predetermined time (S) after the first test signal (38), and monitoring a discharge value signal as an output from the switch.

12. A method according to any one of claims 8 to 11 characterised in that the main circuit (10) forms part of an electronic detonator (10), and which includes the step of programming the electronic detonator with timing signals from a remote controller (21) in the event of the monitored parameters falling within predetermined limits, charging the charge storage device (26) from the remote controller, and allowing the charge storage device to detonate the load (30).

## Patentansprüche

1. Prüfschaltung, **dadurch gekennzeichnet**, daß die Prüfschaltung zum Prüfen der Funktion eines Zünders (30) und eines Ladungsspeichers (26) ausgelegt ist, der Teil einer Hauptschaltung (10) ist und so geschaltet wird, daß er sich in einen Zünder entlädt und diesen zur Explosion bringt, wobei diese Prüfschaltung aus folgenden Elementen besteht:
a) Signalleitvorrichtungen (12) zum Weiterleiten eines von einem Signalgenerator stammenden Prüfsignals (36), das im Ladungsspeicher (26) gespeichert wird;
b) Entladevorrichtungen (24, 40, 42, 44), mit deren Hilfe der Ladungsspeicher (26) ein Entladesignal (46) liefert, indem er die vom Prüfsignal abgeleitete Ladung durch den Zünder entlädt;
c) Überwachungsvorrichtung (52) zum Überwachen mindestens eines der Parameter des Entladesignals (46), und
d) Sperrvorrichtung (64, 73), die in Abhängigkeit von den Informationen der Überwachungsvorrichtung (52) die Funktion der Hauptschaltung sperrt, wenn mindestens einer der überwachten Parameter außerhalb der vorgegebenen Grenzen (58) liegt, wobei diese Grenzen im Hinblick auf die Funktionsfähigkeit sowohl des Zünders (30) als auch des Ladungsspeichers (26) bestimmt werden.

2. Prüfschaltung nach Anspruch 1, **dadurch gekennzeichnet**, daß die Überwachungsvorrichtung einen ersten Schalter (52) beinhaltet, der über das Entladesignal (46) angesteuert wird, wobei der erste Schalter ein Überwachungssignal (51) nach Ablauf einer vorbestimmten Zeitspanne (S) im Anschluß an das Prüfsignal (38) erhält, und wobei der Schalter einen Ausgang (56) hat, um ein Entladewertsignal (60) zu liefern, wenn das Entladesignal (46) unterhalb eines Grenzwertes (58) fällt, der zum Betätigen des ersten Schalters erforderlich ist.

3. Prüfschaltung nach einem der beiden vorangegangenen Ansprüche, **dadurch gekennzeichnet**, daß die Sperrvorrichtung eine Sperre (64) beinhaltet, um den Ausgang der Überwachungsvorrichtung (52) zu sperren.

4. Prüfschaltung nach einem der vorangegangenen Ansprüche, **dadurch gekennzeichnet**, daß die Entladevorrichtung einen zweiten Schalter (44) in einem Entladeweg sowie eine erste Steuervorrichtung (70) zum Steuern der Funktion des zweiten Schalters (44) beinhaltet, wobei die Steuervorrichtung so angeordnet ist, daß der zweite Schalter geöffnet wird, sobald die Prüfschaltung in Betrieb war, und wodurch eine weitere Entladung des Ladungsspeichers (26) im Entladepfad verhindert wird.

5. Prüfschaltung nach einem der vorangegangenen Ansprüche, **dadurch gekennzeichnet**, daß die Überwachungsvorrichtung weiterhin Vorrichtungen (24) zur Generierung eines ersten Signals (68) beinhaltet, welches die Entladevorrichtungen (40, 42, 44) dazu veranlaßt, mit der Entladung des Ladungsspeichers (26) zu beginnen; Vorrichtungen (24) zur Generierung eines zweiten Signals (72) nach Ablauf einer bestimmten Zeitspanne nach Generierung des ersten Signals (68); und Vorrichtungen (64), die in Abhängigkeit vom ersten Signal (72) die Sperrvorrichtung in Funktion der Spannung des Entladesignals bei besagter festgelegten Zeitspanne steuern.

6. Prüfschaltung nach einem der vorangegangenen Ansprüche, **dadurch gekennzeichnet**, daß mindestens ein Teil der Prüfschaltung in einen elektronischen Zünder (10) eingebaut ist, der zusammen mit ähnlichen Zündern über einen Kabelbaum (11') mit einem zentralen Controller verbunden ist.

7. Prüfschaltung nach Anspruch 2 und 6, **dadurch gekennzeichnet**, daß sowohl das Prüfsignal (36) als auch das Überwachungssignal (51) im Controller generiert und über eine jeweils separate Zündstromversorgungsleitung (12) und Logikstromversorgungsleitung (14) übertragen werden.

8. Verfahren zum Prüfen der Funktionsfähigkeit eines Zünders (30) und eines Ladungsspeichers (26) dargestellt, der in einer Hauptschaltung (10) angeordnet ist und seine Ladung an den Zünder abgibt, wobei das Verfahren folgende Schritte beinhaltet:
a) Generieren eines ersten Prüfsignals (36);
b) Speichern des ersten Prüfsignals im Ladungsspeicher (26);
c) Abgabe eines Entladesignals (46) durch Freigabe der Entladung des Ladungsspeichers (26) an den Zünder;
d) Überwachung mindestens eines der Parameter des Entladesignals (46); und
e) Sperren der Funktion der Schaltung für den Fall, daß mindestens einer der überwachten Parameter außerhalb der festgelegten Grenzwerte (58) liegt.

9. Verfahren nach Anspruch 8, **dadurch gekennzeichnet**, daß das Prüfsignal (36) von seiner Stärke und Dauer so ausgelegt ist, daß es nicht in der Lage ist, die Explosion des Zünders (30) beim Entladen über den Zünder auszulösen.

10. Verfahren nach einem der Ansprüche 8 oder 9, **dadurch gekennzeichnet**, daß die Parameter, die überwacht werden, Spannung und Entladesignal beinhalten und sich auf die Entladegeschwindigkeit des Ladungsspeichers (26) beziehen, wobei die Entladegeschwindigkeit die Funktion einer RC-Zeitkonstante ist, und wobei C die Kapazität des Ladungsspeichers (26) und R den Widerstand des Zünders (30) beinhaltet.

11. Verfahren nach einem der Ansprüche 8 bis 10, **dadurch gekennzeichnet**, daß das Verfahren die Schritte einer Betätigung des ersten Schalters (52) durch das Entladesignal (46), die Generierung eines Überwachungssignals (51) und dessen Weiterleitung an den ersten Schalter nach Ablauf einer bestimmten Zeit (S) im Anschluß an das erste Prüfsignal (38), und die Überwachung eines Entladewertsignals, das am Ausgang des Schalters anliegt, beinhaltet.

12. Verfahren nach einem der Ansprüche 8 bis 11, **dadurch gekennzeichnet**, daß die Hauptschaltung (10) ein Teil eines elektronischen Zünders (10) ist, und daß das Verfahren die Programmierung des elektronischen Zünders mit Taktsignalen von einem entfernt angeordneten Controller (21) für den Fall, daß die überwachten Parameter innerhalb festgesetzter Grenzen liegen; das Aufladen des Ladungsspeichers (26) vom Controller aus und die Freigabe des Ladungsspeichers zum Zünden des Zünders (30) beinhaltet.

## Revendications

1. Circuit de test, caractérisé en ce que le circuit de test est adapté pour le test de la capacité de fonctionnement à la fois d'une charge (30) et d'un dispositif de stockage d'une charge électrique (26) incorporé dans un circuit principal (10) et adapté pour se décharger dans la charge pour la détonation de celle-ci, le circuit de test comprenant :
a) des moyens (12) d'acheminement de signaux pour l'acheminement d'un signal de test (36) à partir d'un générateur de signaux (21) pour le stockage dans le dispositif de stockage de charge électrique (26) ;
b) des moyens de décharge (24,40,42,44) pour permettre au dispositif à stockage de charge électrique (26) de fournir un signal de décharge (46) par décharge à travers la charge, de la charge électrique obtenue à partir du signal de test ;
c) des moyens de surveillance (52) pour la surveillance d'au moins un des paramètres du signal de décharge (46), et
d) des moyens d'inhibition (64,73) répondant aux moyens de surveillance (52) pour inhiber le fonctionnement du circuit principal dans le cas où au moins un des paramètres surveillés se situe à l'extérieur de limites prédéterminées (58), les limites étant déterminées par rapport à la capacité de fonctionnement à la fois de la charge (30) et du dispositif à stockage de charge électrique (26).

2. Circuit de test selon la revendication 1, caractérisé en ce que les moyens de surveillance comportent un premier commutateur (52) adapté pour être actionné par le signal de décharge (46), le premier commutateur recevant un signal de surveillance (51) une durée prédéterminée (S) après le signal de test (38), et ayant une sortie (56) pour délivrer une valeur de signal de décharge (60) lorsque le signal de décharge (46) se situe en dessous d'une valeur de seuil (58), qui pilote le premier commutateur.

3. Circuit de test selon l'une quelconque des revendications précédentes, caractérisé en ce que les moyens d'inhibition comportent des moyens de verrouillage (64) pour verrouiller la sortie provenant des moyens de surveillance (52).

4. Circuit de test selon l'une quelconque des revendications précédentes, caractérisé en ce que les moyens de décharge comportent un deuxième commutateur (44) connecté le long d'un trajet de décharge et des premiers moyens de commande (70) pour commander le fonctionnement du deuxième commutateur (44), les moyens de commande étant adaptés pour ouvrir le deuxième commutateur une fois que le circuit de test a fonctionné, de manière à prévenir une autre décharge du dispositif à stockage de charge électrique (26) à travers les moyens de décharge.

5. Circuit de test selon l'une quelconque des revendications précédentes, caractérisé en ce que les moyens de surveillance comportent en outre des moyens (24) pour fournir un premier signal (68) pour provoquer un début de décharge du dispositif à stockage de charge électrique (26) par les moyens de décharge (40,42,44), des moyens (24) pour fournir un deuxième signal (72) une durée fixe après le premier signal (68), et des moyens (64) sensibles au deuxième signal (72) pour commander les moyens d'inhibition en réponse à la tension du signal de décharge à ladite durée fixe.

6. Circuit de test selon l'une quelconque des revendications précédentes, caractérisé en ce qu'au moins une partie du circuit de test est incorporée dans un détonateur (10) électronique, qui est lié, avec d'autres détonateurs similaires, à un dispositif de commande central (21) par l'intermédiaire d'un faisceau de câble (11).

7. Circuit de test selon l'une des revendications 2 et 6, caractérisé en ce qu'à la fois le signal de test (36) et le signal de surveillance (51) sont générés au niveau du dispositif de commande et transmis par l'intermédiaire de lignes de puissance détonantes (12) et de puissance logique (14) séparées, respectives.

8. Procédé de test de la capacité de fonctionnement à la fois d'une charge (30) et d'un dispositif à stockage d'une charge électrique (26) incorporé dans un circuit principal (10) et adapté pour se décharger dans la charge, caractérisé en ce que le procédé comporte les étapes consistant à:
a) générer un premier signal de test (36) ;
b) stocker le premier signal de test dans le dispositif à stockage de charge électrique (26) ;
c) fournir un signal de décharge (46) en autorisant le dispositif à stockage de charge électrique (26) à se décharger par l'intermédiaire de la charge ;
d) surveiller au moins l'un des paramètres du signal de décharge (46); et
e) inhiber le fonctionnement du circuit dans le cas où au moins l'un des paramètres surveillés se situe à l'intérieur de limites prédéterminées (58).

9. Procédé selon la revendication 8, caractérisé en ce que le signal de test (36) a une grandeur et une durée telles qui n'est pas capable d'activer ou de faire détoner la charge (30) lors de la décharge à travers la charge.

10. Procédé selon l'une des revendications 8 ou 9, caractérisé en ce que les paramètres qui sont surveillés comportent la tension du signal de décharge et se rapportent au taux de décharge du dispositif à stockage de charge électrique (26), le taux de décharge étant une fonction d'une constante de temps RC, dans laquelle C est la capacité d'un condensateur (26) et R comporte la résistance de la charge (30).

11. Procédé selon l'une quelconque des revendications 8 à 10, caractérisé en ce qu'il comporte les étapes consistant à autoriser le signal de décharge (46) à faire fonctionner un premier commutateur (52), générer un signal de surveillance (51) et fournir celui-ci au premier commutateur, après une durée (S) prédéterminée par rapport au premier signal de test (38), et surveiller un signal de valeur de décharge en tant que sortie du commutateur.

12. Procédé selon l'une quelconque des revendications 8 à 11, caractérisé en ce que le circuit principal (10) forme une partie d'un détonateur électronique (10), et en ce qu'il comporte l'étape consistant à programmer le détonateur électronique avec des signaux d'horloge à partir d'un dispositif de commande à distance (21), dans le cas où les paramètres surveillés se situent à l'intérieur de limites prédéterminées, charger le dispositif à stockage de charge électrique (26) à partir du dispositif de commande à distance, et autoriser le dispositif à stockage de charge électrique à faire détoner la charge (30).
